Europäisches Patentamt

European Patent Office

Office européen des brevets

(19)

(11) EP 0 461 442 B1

(12) **EUROPÄISCHE PATENTSCHRIFT**

(45) Veröffentlichungstag und Bekanntmachung des Hinweises auf die Patenterteilung:
**18.09.1996 Patentblatt 1996/38**

(51) Int Cl.$^6$: **H01J 37/28**, H01J 37/04, H01J 37/12

(21) Anmeldenummer: **91108372.3**

(22) Anmeldetag: **23.05.1991**

(54) **Teilchenstrahlgerät**

Particle beam apparatus

Appareil à faisceau de particules

(84) Benannte Vertragsstaaten:
**DE FR GB IT NL**

(30) Priorität: **11.06.1990 DE 4018690**

(43) Veröffentlichungstag der Anmeldung:
**18.12.1991 Patentblatt 1991/51**

(73) Patentinhaber: **ICT Integrated Circuit Testing Gesellschaft für Halbleiterprüftechnik mbH D-85551 Kirchheim (DE)**

(72) Erfinder: **Plies, Erich, Dr. rer. nat. W-8000 München 83 (DE)**

(74) Vertreter: **Tetzner, Volkmar, Dr.-Ing. Dr. jur. Van-Gogh-Strasse 3 81479 München (DE)**

(56) Entgegenhaltungen:
**EP-A- 0 194 570**

- **JOURNAL OF VACUUM SCIENCE AND TECHNOLOGY: PART B. Bd. 7, Nr. 6, Dezember 1989, NEW YORK US Seiten 1874 - 1877; J. FROSIEN ET AL.: 'Compound magnetic and electrostatic lenses for low-voltage applications.'**
- **REVIEW OF SCIENTIFIC INSTRUMENTS. Bd. 59, Nr. 8, August 1988, NEW YORK US Seiten 1294-1302; G.P:MALAWSKI ET AL.:'transport optics for a space-charge broadening ion beam.'**

## Beschreibung

Die Erfindung betrifft ein Teilchenstrahlgerät nach dem Oberbegriff des Patentanspruchs 1.

In allen Bereichen der Entwicklung und Fertigung mikro- und optoelektronischer Bauelemente besteht ein steigender Bedarf an hochauflösenden Rasterelektronenmikroskopen, um Submikrometerstrukturen visuell beurteilen, Abweichungen von Sollmustern feststellen und topographische Parameter wie Höhen, Breiten oder Neigungswinkel erfassen und auswerten zu können. Konventionelle Rasterelektronenmikroskope erreichen die geforderte Ortsauflösung von Bruchteilen eines Mikrometers bis hin zu wenigen Nanometern allerdings erst bei kleinen Arbeitsabständen und hohen Beschleunigungsspannungen oberhalb von etwa 20 kV, wo Resiststrukturen und integrierte Schaltungen durch die hochenergetischen Elektronen geschädigt und nichtleitende oder schlechtleitende Proben aufgeladen werden.

Erst mit der Entwicklung aberrationsarmer Kondensor- und Objekivlinsen war die Möglichkeit gegeben, Rasterelektronenmikroskope und Elektronenstrahlmeßgeräte zu konstruieren, die auch bei niedrigen Strahlenergien im Bereich von etwa 0,5 bis 3 keV die für hochgenaue Messungen erforderliche Ortsauflösung erreichen. In den beispielsweise aus US-A 4 785 176, 4 831 266, 4 728 790 oder Microelectronic Engineering Vol. 7, Nr. 2 bis 4 (1987) Seiten 163 bis 172 bekannten Linsen nutzt man hierbei die Erkenntnis, daß ein dem fokussierenden Magnetfeld überlagertes elektrostatisches Verzögerungsfeld die Linsenaberrationen bei gleichem Arbeitsabstand erheblich verringert.

Neben den Linsenaberrationen begrenzt auch der sogenannte Boersch-Effekt die Ortsauflösung. In den US-A 4 713 543 und 4 675 524 wurde daher vorgeschlagen, die Elektronen im Strahlerzeuger auf eine hohe Energie von beispielsweise $E \gtrsim 10$ keV zu beschleunigen, um sie erst unmittelbar oberhalb der Probe auf die gewünschte niedrige Endenergie von beispielsweise $E \lesssim 1$ keV abzubremsen.

Aus der US-A 4 896 036 ist ein Rasterelektronenmikroskop bekannt, in dem man die Aberrationen einer elektrostatischen Detektorobjektivlinse mit Hilfe eines aus mehreren Multipolelementen bestehenden Korrektors verringert.

Allen genannten Lösungsvorschlägen zur Verbesserung der Ortsauflösung erfordern eine Neukonstruktion der elektronenoptischen Säule oder zumindest eine erhebliche Modifikation der REM-Elektronik, so daß man diese fehlerarmen aber auch komplexen Linsensysteme in konventionellen Geräten nicht verwenden kann.

Aus JOURNAL OF VACUUM SCIENCE AND TECHNOLOGY: Part B. Bd. 7, Nr. 6, Dezember 1989, New York, US, S. 1874 - 1877,; J. Frosien et al: "Compund magnetic and electrostatic lenses for low-voltage applications" ist ein Teilchenstrahlgerät gemäß dem Oberbegriff des Anspruches 1 bekannt. Hierbei werden die Teilchen zunächst in einem ersten Linsensystem abgebremst, um dann in der nachfolgenden Objektivlinse zunächst beschleunigt und anschließend wieder abgebremst zu werden.

Der Erfindung liegt daher die Aufgabe zugrunde, ein Teilchenstrahlgerät gemäß dem Oberbegriff des Anspruches 1 anzugeben, daß die Nachteile des Stands der Technik vermeidet und auch bei niedrigen Strahlenergien eine hohe Ortsauflösung besitzt.

Diese Aufgabe wird erfindungsgemäß durch das kennzeichnende Merkmal des Anspruches 1 gelöst.

Der mit der Erfindung erzielbare Vorteil besteht insbesondere darin, daß die Ortsauflösung eines konventionellen Rasterelektronenmikroskops bei niedrigen Strahlenergien und vergleichsweise großen Arbeitsabständen deutlich verbessert werden kann. Die Umrüstung für den Niederenergiebetrieb gestaltet sich sehr einfach, da man im wesentlichen nur eine zusätzliche Rohrelektrode, ein Hochspannungsnetzgerät sowie isolierende Halterungen zur Anordnung der Rohrelektrode in der Säule des Rasterelektronenmikroskops benötigt.

Die abhängigen Ansprüche betreffen vorteilhafte Weiterbildungen der im folgenden anhand der Zeichnungen näher erläuterten Erfindung. Hierbei zeigt

| | |
|---|---|
| Fig. 1 und 2 | den schematischen Aufbau eines kotivencionelien und eines für niedrige Strahlenergien ausgelegten Rasterelektronenmikroskops |
| Fig. 3 | ein Ausführungsbeispiel eines erfindungsgemäßen Rasterelektronenmikroskops |
| Fig. 4 | die elektrische Potentialverteilung innerhalb der Objektivlinse des erfindungsgemäßen Rasterelektronenmikroskops |
| Fig. 5 | die berechneten Elektronenbahnen $r_\alpha(z)$ und $\tau_\alpha^*(z)$ innerhalb einer rein magnetischen bzw. einer elektrostatisch-magnetischen Objektivlinse. Beide Bahnen schneiden die optische Achse OA (z-Achse) in der Probenebene und besitzen dort dieselbe Steigung. |

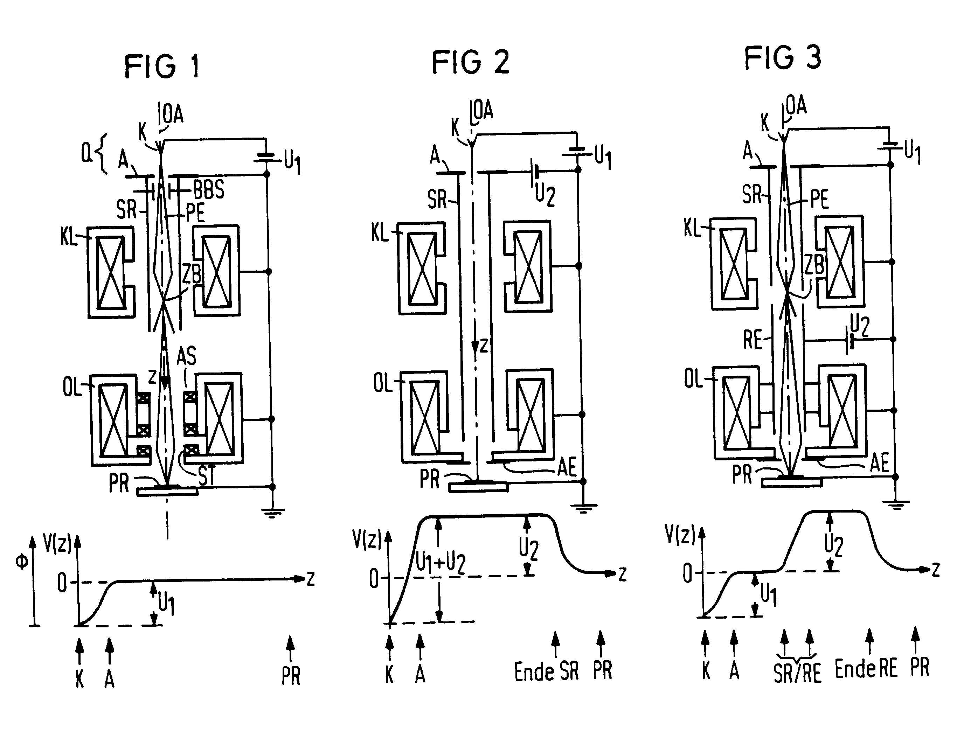

Wie die Fig. 1 schematisch zeigt, umfaßt ein konventionelles Rasterelektronenmikroskop üblicherweise einen Elektronenstrahlerzeuger Q, eine aus einer oder zwei Polschuhlinsen bestehende Kondensoreinheit KL und eine Objektivlinse OL, die das von der Kondensoreinheit KL erzeugte Zwischenbild ZB der virtuellen Elektronenquelle verkleinert auf die Probe PR abbildet. Ferner enthält die elektronenoptische Säule noch ein Strahlaustastsystem BBS, eine Ablenkeinheit AS zur Positionierung des Elektronenstrahls auf der Probe PR sowie einen der Korrektur des Astigmatismus dienenden Stigmator ST. Die nicht dargestellten Detektoren zum Nachweis der auf der Probe PR ausgelösten Sekundärelektronen und der von der Probe PR rückgestreuten Primärelektronen ordnet man üblicherweise seitlich unterhalb bzw. oberhalb der Objektivlinse OL an.

Als Objektivlinse OL findet eine unsymmetrische Magnetlinse Verwendung, deren Polschuhe den von der Erregerspule erzeugten magnetischen Fluß auf einen kleinen Raumbereich um die optische Achse OA (z-Achse) konzentrieren, wobei das um diese Achse OA rotationssymmetrische Magnetfeld im Polschuhspalt seine maximale Stärke erreicht.

Da sowohl die Probe PR als auch die Objektivlinse OL, die Kondensoreinheit KL, die Anode A und das bis in die Kondensoreinheit KL hineinreichende Strahlführungsrohr SR auf Masse liegen, werden die Elektronen PE bereits im Strahlerzeuger Q auf die gewünschte Endenergie $E = e\,U_1$ beschleunigt (s. den unteren Teil der Fig. 1, die den gerätemassebezogenen Potentialverlauf V(z) auf der Strahlachse und die Lage der Kathode K, der Anode A und der Probe PR zeigt). Hierbei bezeichnet e die Elementarladung und $U_1$ die zwischen Kathode K und Anode A aufgebaute Potentialdifferenz.

Die dem Strahldurchmesser d auf der Probe PR proportionale Ortsauflösung wird bei niedrigen Beschleunigungsspannungen $U_1 \lesssim 3$ kV im wesentlichen von der der Fokussierung entgegenwirkenden Elektron-Elektron-Wechselwirkung (Boersch-Effekt) und dem axialen Farbfehler der Objektivlinse OL begrenzt. Der Strahldurchmesser d berechnet sich hierbei näherungsweise zu

$$d = (d_C^2 + d_F^2)^{1/2} \qquad (1)$$

wobei $d_C$ den um die Coulomb-Abstoßung der Elektronen im Strahlengang zwischen Kathode K und Probe PR (lateraler Boersch-Effekt) erweiterten geometrisch-optischen Sondendurchmesser und $d_F$ den Durchmesser des durch den Farbfehler der Objektivlinse OL erzeugten Fehlerscheibchens bezeichnet. Wie aus Gleichung (2) ersichtlich, hängt die Größe $d_F$ von der Strahlapertur $\alpha$, dem Farbfehlerkoofizienten $C_F$ der Objektivlinse OL, der Elektronenenergie $E = e\,U_1$ und der Breite $e\Delta U$ der Energieverteilung der Elektronen ab.

$$d_F = C_F \alpha \Delta U / U_1 \qquad (2)$$

Da die Farbfehlerkonstante $C_F$ der Brennweite f der Linse proportional ist, läßt sich der Strahldurchmesser d und damit die Ortsauflösung durch eine Verringerung der Brennweite verbessern. Dem sind allerdings enge Grenzen gesetzt, da man die Probe PR dann sehr nahe unterhalb der Objektivlinse OL, d. h. in deren Magnetfeld anordnen muß. Außerdem können größere Proben dann nicht mehr im geneigten Zustand abgetastet werden. Eine weitere Verbesserung der Ortsauflösung ist daher nur durch eine Verringerung des Boersch-Effektes (Unterdrückung des die Energiebreite e $\Delta U$ beeinflussenden energetischen Boersch-Effektes und des eine Aufweitung des Strahls bewirkenden lateralen Boersch-Effektes) und der Aberrationen des abbildenden Systems möglich.

In dem in Fig. 2 dargestellten Rasterelektronenmikroskop wird diesen Erfordernissen dadurch Rechnung getragen, daß man die Anode A mit einem bezüglich Masse hohen postiven Potential beaufschlagt und das mit der Anode A leitend verbundene Strahlführungsrohr SR bis in den Bereich des Polschuhspaltes der Objektivlinse OL verlängert. Da die Elektronen nahezu die gesamte Säule des Rasterelektronenmikroskops mit einer hohen Energie $E = e\,(U_1 + U_2)$ von beispielsweise $E = 10$ keV durchlaufen und erst innerhalb der Objektivlinse OL in dem zwischen dem Strahlführungsrohr SR und dem auf Masse liegenden unteren Polschuh aufgebauten elektrischen Feld auf die gewünschte Endenergie von beispielsweise $E = e\,U_1 = 1$ keV abgebremst werden, verringert sich der Einfluß des Boersch-Effektes erheblich. Außerdem besitzt die Objektivlinse aufgrund des dem fokussierenden Magentfeld überlagerten elektrischen Verzögerungsfelds deutlich kleinere Farb- und Öffnungsfehlerkonstanten als die rein magnetische Objektivlinse des Rasterelektronenmikroskops nach Fig. 1. Die unterhalb der Objektivlinse OL angeordnete und ebenfalls auf Masse liegende Elektrode AE dient der Abschirmung der Probe PR.

Da das Strahlführungsrohr SR auf Hochspannung $U_2$ liegt (s. den unteren Teil der Fig. 2, die ebenfalls den gerätemassebezogenen Potentialverlauf V(z) bzw. kathodebezogenen Potentialverlauf $\Phi(z)$ auf der Strahlachse und die Lage des Strahlrohrendes zeigt), sind in diesem Rasterelektronenmikroskop erhebliche Modifikationen der REM-Elektronik, insbesondere der Komponenten zur Ansteuerung des ebenfalls mit dem Beschleunigungspotential beaufschlagten Strahlaustastsystem, erforderlich.

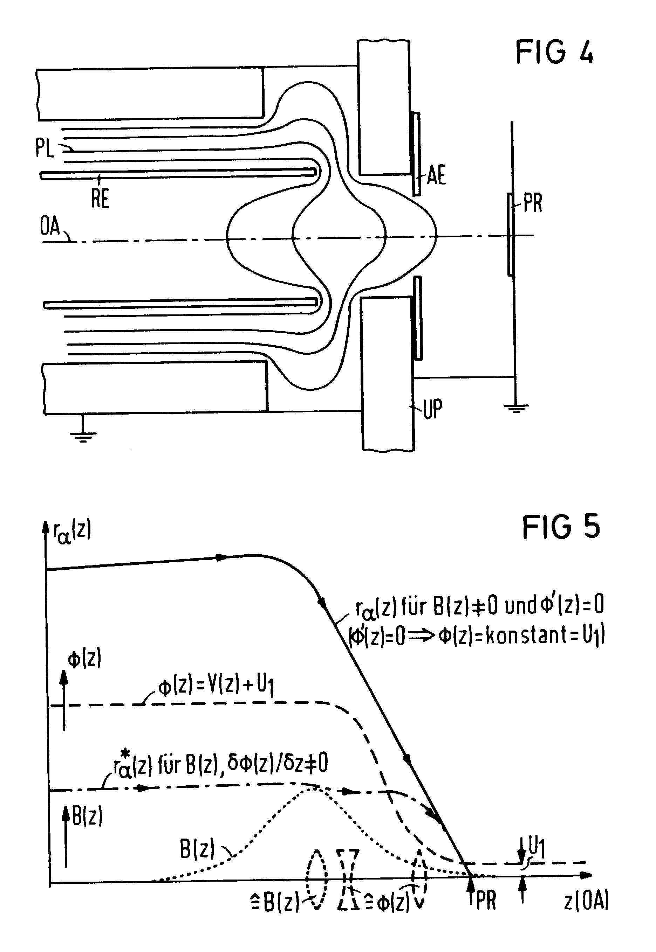

Zur Verbesserung der Ortsauflösung eines konventionellen Rasterelektronenmikroskops bei niedrigen Energien $E \lesssim 3$ keV wird erfindungsgemäß vorgeschlagen, eine elektrostatische Immersionslinse am Ort des von der Kondensoreinheit KL erzeugten Zwischenbildes ZB anzuordnen. Die Lage dieses letzten Zwischenbildes ZB vor der Objektivlinse OL wird in einem konventionellen Rasterelektronenmikroskop mit Doppelkondensor üblicherweise festgehalten. Wie in Fig. 3 schematisch dargestellt, besteht die der Beschleunigung der Primärelektronen PE dienende Immersionslinse aus dem bereits vorhandenen und gegebenenfalls verlängernden oder gekürzten Strahlführungsrohr SR sowie einer zusätzlichen Rohrelektrode RE, die man in der Säule isoliert anordnet und mit einem positiven Potential von beispielsweise $U_2 = 10$ kV beaufschlagt. Zusätzliche Aberrationen werden durch das zwischen den Rohrenden der Elektroden SR und RE aufgebauten Beschleunigungsfeld nicht verursacht, da man dessen Linsenwirkung optisch eliminiert (das Zwischenbild ZB liegt in der Immersionslinse). Wie der untere Teil der Fig. 3 zeigt, laufen die Elektronen PE in der Säule mit einer vergleichsweise hohen mittleren kinetischen Energie, wodurch sich der Einfluß des Boersch-Effektes auf den Sondendurchmesser entsprechend vermindert. Außerdem besitzt die Objektivlinse OL aufgrund des dem fokussierenden Magnetfeld überlagerten elektrostatischen Verzögerungsfeldes sehr kleine Farb- und Öffnungsfehlerkonstanten. Das Verzögerungsfeld erzeugt man hierbei mit Hilfe der aus der Rohrelektrode RE und dem auf Masse liegenden unteren Polschuh PE gebildeten Immersionslinse (s. Fig. 4). Unterhalb der Objektivlinse OL ist wiederum eine Abschirmelektrode AE vorgesehen, um den Durchtritt des in Fig. 4 durch Potentiallinien PL angedeuteten Verzögerungsfeldes auf die Probe PR zu verhindern.

Wie die in Fig. 5 dargestellten Ergebnisse einer Simulationsrechnungen zeigen, verläuft die axiale Elektronenbahn $r_\alpha(z)$ (durchgezogene Linie) in einer ein rein magnetisches Feld B (z) (punktierte Linie) erzeugenden Objektivlinse sehr weit außerhalb der optischen Achse, während die von derselben Zwischenbildlage ausgehenden Elektronen die elektrostatischmagnetische Linse im achsennahen Bereich durchsetzen (strichpunktierte Linie $r_\alpha^*(z)$). Demzufolge sind auch die Farb- und Öffnungsfehlerkonstanten des letztgenannten Linsentyps entsprechend kleiner, da diese sich jeweils aus Integralen über Polynome von $r_\alpha^*$ (z) und deren Ableitungen vom Grade 2 und 4 berechnen. Anhand der Fig. 5 ist auch zu erkennen, daß die Fokussierung der Elektronen im elektrostatisch-magnetischen Feld (B (z) ≠ 0, $\partial\Phi$ (z)/∂z ≠ 0, Φ(z) = V (z) + $U_1$) komplizierter verläuft als im rein magnetischen Feld (B(z) ≠ 0, ∂Φ(z)/∂z = 0). Da die das Verzögerungsfeld erzeugende Immersionslinse sich ersatzweise in eine zerstreuende und eine fokussierende Komponente unterteilen läßt und man diese vorzugsweise im Strahlengang hinter der magnetischen Linse anordnet, werden die Elektronen im magnetischen Feld zuerst in Richtung der optischen Achse (z-Achse) abgelenkt, in der zerstreuenden Komponente leicht von der Achse weggebrochen um anschließend mit Hilfe der konvergenten Komponente auf die Achse fokussiert zu werden. Bei gleicher Steigung $\partial r_\alpha$ (z)/∂z bzw. $\partial r_\alpha^*$(z)/∂(z) in der Ebene der Probe PR ist die Größe $r_\alpha^*$(z)stets kleiner als $r_\alpha$ (z) in der rein magnetischen Linse, so daß auch die Aberrationsintegrale für die Farb- und Öffnungsfehlerkonstante entsprechend kleiner werden.

Die Erfindung ist selbstverständlich nicht auf die beschriebenen Ausführungsbeispiele begrenzt. So ist es ohne weiteres möglich, die aus einer oberen und einer unteren Rohrelektrode bestehende Immersionslinse auch in einem anderen Teilchenstrahlgerät, insbesondere in einem Ionenstrahlgerät zur Beschleunigung der Teilchen von einer ersten auf eine höhere zweite Energie zu verwenden.

**Patentansprüche**

1. Teilchenstrahlgerät mit einem Teilchenstrahlerzeuger (Q) einem ersten Linsensystem (KL) zur Bündelung des Teilchenstrahls und einem zweiten Linsensystem (OL) zur Abbildung eines vom ersten Linsensystem (KL) erzeugten Zwischenbildes (ZB) auf eine Probe (PR), wobei im Zwischenbild (ZB) Mittel (SR, RE) zur Beschleunigung der Teilchen (PE) von einer ersten auf eine höhere zweite Energie angeordnet sind, **gekennzeichnet durch** eine erste Immersionslinse (SR, RE) als Mittel zur Beschleunigung der Teilchen (PE).

2. Teilchenstrahlgerät nach Anspruch 1, **dadurch gekennzeichnet**, daß die erste Immersionslinse eine obere und eine untere Elektrode (SR, RE) aufweist, wobei die obere Elektrode (SR) auf dem Potential einer Anode (A) des Teilchenstrahlerzeugers (Q) liegt.

3. Teilchenstrahlgerät nach Anspruch 2, **dadurch gekennzeichnet**, daß die obere und die untere Elektrode (SR, RE) jeweils die Form eines konzentrisch zur Strahlachse (OA) des ersten unc zweiten Linsensystems (KL, OL) angeordneten Hohlzylinders a weisen.

4. Teilchenstrahlgerät nach Anspruch 2 oder 3, **gekennzeichnet durch** ein mit der Anode (A) verbundenes Strahlführungsrohr (SR) als obere Elektrode der ersten Immersionslinse.

5. Teilchenstrahlgerät nach einem der Ansprüche 1 bis 4, **dadurch gekennzeichnet**, daß das zweite Linsensystem eine ein die Teilchen (PE) fokussierendes Magnetfeld erzeugende Objektivlinse (OL) und eine zweite Immersionslinse (RE, UP) aufweist, wobei die zweite Immersionslinse (RE, UP) derart angeordnet ist, daß sich deren elektrisches Verzögerungsfeld dem fokussierenden Magnetfeld überlagert.

6. Teilchenstrahlgerät nach einem der Ansprüche 2 bis 5, **dadurch gekennzeichnet**, daß eine obere Elektrode der zweiten Immersionslinse auf dem Potential der unteren Elektrode (RE) der ersten Immersionslinse liegt.

7. Teilchenstrahlgerät nach einem der Ansprüche 2 bis 6, **dadurch gekennzeichnet**, daß die obere Elektrode (RE) der zweiten Immersionslinse die Form eines in die Objektivlinse (OL) hineinragenden Hohl-zylinders aufweist.

8. Teilchenstrahlgerät nach einem der Ansprüche 2 bis 7,
**dadurch gekennzeichnet**,
daß die untere Elektrode der ersten Immersionslinse (SR, RE) identisch ist mit der oberen Elektrode der zweiten Immersionslinse (RE, UP).

9. Teilchenstrahlgerät nach einem der Ansprüche 1 bis 8,
**gekennzeichnet durch**
Mittel (AS) zur Ablenkung des Teilchenstrahls auf der Probe (PR).

10. Teilchenstrahlgerät nach einem der Ansprüche 1 bis 9,
**gekennzeichnet durch**
Mittel (BBS) zur Modulation der Intensität des Teilchenstrahls.

11. Teilchenstrahlgerät nach einem der Ansprüche 1 bis 10,
**gekennzechnet durch**
Mittel zum Nachweis der auf der Probe (PR) ausgelösten oder von der Probe (PR) rückgestreuten Sekundärteilchen.

12. Teilchenstrahlgerät nach einem der Ansprüche 1 bis 11,
**dadurch gekennzeichnet**,
daß das erste Linsensystem eine oder zwei Kondensorlinsen (KL) aufweist.

13. Teilchenstrahlgerät nach einem der Ansprüche 1 bis 12,
**dadurch gekennzeichnet**,
daß die Mittel (SR, RE) zur Beschleunigung der Teilchen (PE) im letzten Zwischenbild (ZB) vor der Objektivlinse (OL) angeordnet sind.

**Claims**

1. Particle beam apparatus with a particle beam generator (Q), a first lens system (KL) for focusing the particle beam and a second lens system (OL) for imaging an intermediate image (ZB) of the particle beam produced by the first lens system (KL) onto a specimen (PR), wherein means (SR, RE) for accelerating the particles (PE) from a first energy to a higher second energy are disposed in the intermediate image (ZB), characterised by a first immersion lens (SE, RE) as means for accelerating the particles (PE).

2. Particle beam apparatus as claimed in Claim 1, characterised in that the first immersion lens has an upper and a lower electrode (SR, RE), wherein the upper electrode (SR) is at the potential of an anode (A) of the particle beam generator (Q).

3. Particle beam apparatus as claimed in Claim 2, characterised in that the upper and the lower electrode (SR, RE) in each case have the shape of a hollow cylinder disposed concentrically with respect to the beam axis (OA) of the first and second lens system (KL, OL).

4. Particle beam apparatus as claimed in Claim 2 or 3, characterised by a beam-guiding tube (SR) connected to the anode (A) as upper electrode of the first immersion lens.

5. Particle beam apparatus as claimed in one of Claims 1 to 5, characterised in that the second lens system has an objective lens (OL) which generates a magnetic field which focuses the particles (PE) and a second immersion lens (RE, UP), the second immersion lens (RE, UP) being disposed in such a way that the electrical retarding field thereof overlays the focusing magnetic field.

6. Particle beam apparatus as claimed in one of Claims 2 to 5, characterised in that an upper electrode of the second immersion lens is at the potential of the lower electrode (RE) of the first immersion lens.

7. Particle beam apparatus as claimed in one of Claims 2 to 6, characterised in that the upper electrode (RE) of the second immersion lens has the shape of a hollow cylinder projecting into the objective lens (OL).

8. Particle beam apparatus as claimed in one of Claims 2 to 7, characterised in that the lower electrode of the first immersion lens (SR, RE) is identical to the upper electrode of the second immersion lens (RE, UP).

9. Particle beam apparatus as claimed in one of Claims 1 to 8, characterised by means (AS) for deflecting the particle beam on the specimen (PR).

10. Particle beam apparatus as claimed in one of Claims 1 to 9, characterised by means (BBS) for modulating the intensity of the particle beam.

11. Particle beam apparatus as claimed in one of Claims 1 to 10, characterised by means for documenting the secondary particles triggered on the specimen (PR) or back-scattered from the specimen (PR).

12. Particle beam apparatus as claimed in one of Claims 1 to 11, characterised in that the first lens system has one or two condenser lenses (KL).

13. Particle beam apparatus as claimed in one of Claims 1 to 12, characterised in that the means (SR, RE) for accelerating the particles (PE) are disposed in the last intermediate image (ZB) preceding the objective lens (OL).

## Revendications

1. Canon à particules comprenant un générateur (Q) d'un faisceau de particules, un premier système de lentille (KL) destiné à la concentration du faisceau de particules et un second système de lentilles (OL) destiné à reproduire une image intermédiaire (ZB) générée par le premier système de lentille (KL) sur un échantillon (PR), dans lequel des moyens (SR, RE) d'accélération des particules (PE) d'une première énergie à une seconde énergie supérieure sont disposés dans l'image intermédiaire (ZB),

   caractérisé par

   une première lentille à immersion (SR, RE) constituant le moyen d'accélération des particules (PE).

2. Canon à particules selon la revendication 1, caractérisé en ce que la première lentille à immersion comprend une électrode supérieure et une électrode inférieure (SR, RE), l'électrode supérieure (SR) étant au potentiel de l'anode (A) du générateur (Q) du faisceau de particules.

3. Canon à particules selon la revendication 2, caractérisé en ce l'électrode supérieure et l'électrode inférieure (SR, RE) ont toutes deux la forme d'un cylindre creux disposé concentriquement à l'axe du faisceau (OA) du premier et du second système de lentilles (KL, OL).

4. Canon à particules selon la revendication 2 ou 3, caractérisé par un tube de guidage du faisceau (SR) connecté à l'anode (A) et constituant l'électrode supérieure de la première lentille à immersion.

5. Canon à particules selon l'une des revendications 1 à 4, caractérisé en ce que le second système de lentilles comprend une lentille d'objectif (OL) générant un champ magnétique focalisant les particules (PE) et une seconde lentille à immersion (RE, UP), la seconde lentille à immersion (RE, UP) étant disposée de manière que son champ électrique de décélération se superpose au champ magnétique de focalisation.

6. Canon à particules selon l'une des revendications 2 à 5, caractérisé en ce qu'une électrode supérieure de la seconde lentille à immersion est au potentiel de l'électrode inférieure (RE) de la première lentille à immersion.

7. Canon à particules selon l'une des revendications 2 à 6, caractérisé en ce que l'électrode supérieure (RE) de la seconde lentille à immersion a la forme d'un cylindre creux pénétrant dans la lentille d'objectif (OL).

8. Canon à particules selon l'une des revendications 2 à 7, caractérisé en ce que l'électrode inférieure de la première lentille à immersion (SR, RE) est identique à l'électrode supérieure de la seconde lentille à immersion (RE, UP).

9. Canon à particules selon l'une des revendications 1 à 8, caractérisé par des moyens (AS) de déviation du faisceau de particules sur l'échantillon (PR).

10. Canon à particules selon l'une des revendications 1 à 9, caractérisé par des moyens (BBS) de modulation de l'intensité du faisceau de particules.

11. Canon à particules selon l'une des revendications 1 à 10, caractérisé par des moyens pour mettre en évidence les particules secondaires libérées sur l'échantillon (PR) ou rétrodiffusées par l'échantillon (PR).

12. Canon à particules selon l'une des revendications 1 à 11, caractérisé en ce que le premier système de lentille comprend une ou deux lentilles de condenseur (KL).

13. Canon à particules selon l'une des revendications 1 à 12, caractérisé en ce que les moyens (SR, RE) d'accélération des particules (PE) sont disposés dans la dernière image intermédiaire (ZB) située devant la lentille d'objectif (OL).

FIG 1　　FIG 2　　FIG 3

## FIG 4

## FIG 5

$r_\alpha(z)$ für $B(z) \neq 0$ und $\Phi'(z)=0$
($\Phi'(z)=0 \Rightarrow \Phi(z)=$ konstant $= U_1$)

$\Phi(z) = V(z) + U_1$

$r_\alpha^*(z)$ für $B(z), \delta\Phi(z)/\delta z \neq 0$

$B(z)$

$\hat{=} B(z)$   $\hat{=} \Phi(z)$   $U_1$

$\uparrow$PR   $z(OA)$